# EUROPÄISCHE PATENTSCHRIFT

(11) **EP 2 514 049 B1**
(45) Veröffentlichungstag und Bekanntmachung des Hinweises auf die Patenterteilung: **08.08.2018**
(21) Anmeldenummer: 10779771.4
(22) Anmeldetag: 12.11.2010
(51) Int. Cl.: H01S 5/02, H01S 5/042, H01S 5/22, H01S 5/323, H01L 33/16, H01L 33/32

(54) **Verfahren zur Herstellung lichtemittierender Halbleiterkörper**
Process for manufacturing light emitting semiconductor elements
Procédé de fabrication d'éléments électroluminescents semi-conducteurs

(30) Priorität: 15.12.2009 DE 102009058345
(43) Veröffentlichungstag der Anmeldung: 24.10.2012
(73) Patentinhaber: OSRAM Opto Semiconductors GmbH, 93055 Regensburg (DE)
(72) Erfinder: DINI, Dimitri, 80939 München (DE); SCHILLGALIES, Marc, 12049 Berlin (DE)
(74) Vertreter: Epping - Hermann - Fischer
(86) Internationale Anmeldenummer: PCT/EP2010/067402
(87) Internationale Veröffentlichungsnummer: WO 2011/072964

(56) Entgegenhaltungen:
- EP-A2- 0 874 405
- WO-A1-2008/047751
- JP-A- 2009 200 341
- US-A1- 2004 041 156
- US-A1- 2005 042 787
- US-A1- 2008 073 664
- US-A1- 2008 130 698
- US-A1- 2009 185 594

## Beschreibung

Das vorliegende Patent betrifft ein Verfahren zur Herstellung eines Halbleiterlasers.

Bei der Herstellung von Halbleiterlasern auf der Basis von nitridischen Verbindungshalbleitern stellen insbesondere auch die für eine hohe Kristallqualität erforderlichen hochwertigen Aufwachssubstrate einen erheblichen Kostenfaktor dar.

Aus den Druckschriften US 2008/0130698 A1 und JP 2009-200341 sind Nitrid-basierte Halbleiterbauelemente bekannt.

Eine der vorliegenden Anmeldung zugrunde liegende Aufgabe ist es, ein kostengünstiges Verfahren zur Herstellung eines Halbleiterlasers von hoher Qualität anzugeben.

Diese Aufgabe wird durch ein Verfahren gemäß dem Patentanspruch 1 gelöst. Ausgestaltungen und Weiterbildungen sind Gegenstand der abhängigen Patentansprüche.

In einem Beispiel weist der Halbleiterlaser einen Halbleiterkörper mit einem zur Erzeugung von Strahlung vorgesehenen aktiven Bereich und einen stegförmigen Bereich auf. Der stegförmige Bereich weist eine entlang einer Emissionsrichtung verlaufende Längsachse auf, wobei die Längsachse bezüglich einer in Emissionsrichtung verlaufenden Mittelachse des Halbleiterkörpers in Querrichtung versetzt angeordnet ist.

Unter einer Querrichtung wird hierbei eine Richtung verstanden, die in der Ebene der Halbleiterschichten des Halbleiterkörpers senkrecht zur Emissionsrichtung verläuft.

Unter einer Mittelachse wird im Zweifel eine Achse verstanden, die mittig bezüglich zweier den Halbleiterkörper jeweils in Querrichtung begrenzenden Seitenflächen, also äquidistant zu diesen Seitenflächen, verläuft.

Mit anderen Worten weist der stegförmige Bereich also in Querrichtung zu einer dieser Seitenflächen einen größeren Abstand auf als zu der anderen Seitenfläche.

Unter der Längsachse des stegförmigen Bereichs wird im Zweifel eine Achse verstanden, die durch den Schwerpunkt des stegförmigen Bereichs in Emissionsrichtung verläuft.

Die Mittelachse des Halbleiterkörpers und die Längsachse des stegförmigen Bereichs verlaufen vorzugsweise parallel oder zumindest im Wesentlichen parallel zueinander, sind aber aufgrund des Versatzes in Querrichtung nicht deckungsgleich.

Unter einer Anordnung mit einem Versatz wird hierbei eine gezielte Beabstandung der Längsachse von der Mittelachse verstanden.

Ein lediglich durch Fertigungstoleranzen bedingter Abstand zwischen der Längsachse und der Mittelachse, beispielsweise aufgrund von Justageungenauigkeiten bei einer photolithographischen Strukturierung, wird im Gegensatz dazu nicht als ein Versatz im Sinne der vorliegenden Anmeldung verstanden.

In einer Ausgestaltung ist der stegförmige Bereich im Halbleiterkörper ausgebildet. Somit kann der stegförmige Bereich der Wellenführung innerhalb des Halbleiterkörpers dienen. Weiterhin bevorzugt ist der aktive Bereich zumindest teilweise innerhalb des stegförmigen Bereichs angeordnet. In diesem Fall begrenzen die Seitenflächen des stegförmigen Bereichs den aktiven Bereich in Querrichtung. Davon abweichend kann der aktive Bereich aber auch in vertikaler Richtung, also in einer senkrecht zur Haupterstreckungsebene der Halbleiterschichtenfolge des Halbleiterkörpers verlaufenden Richtung, vom stegförmigen Bereich beabstandet sein.

In einer alternativen Ausgestaltung ist der stegförmige Bereich auf dem, insbesondere vorgefertigten, Halbleiterkörper ausgebildet. Beispielsweise kann der stegförmige Bereich mittels einer Kontaktschicht ausgebildet sein.

Beispielsweise weist der Halbleiterkörper in Querrichtung einen Versetzungsgradienten auf. Das heißt, die Versetzungsdichte des Halbleiterkörpers ist inhomogen und die statistische Verteilung der Versetzungen variiert in Querrichtung. Ein solcher Versetzungsgradient kann insbesondere bei Verwendung eines Aufwachssubstrats für die Halbleiterschichten des Halbleiterkörpers auftreten, das selbst eine inhomogene Versetzungsdichte aufweist.
Weiterhin bevorzugt ist die Längsachse des stegförmigen Bereichs auf der Seite der Mittelachse angeordnet, in dem die Versetzungsdichte geringer ist. So kann erzielt werden, dass im Betrieb des Halbleiterkörpers die Strahlung bezogen auf die Querrichtung des Halbleiterkörpers überwiegend in dem Bereich erzeugt wird, in dem die Versetzungsdichte niedrig und somit die Kristallqualität des aktiven Bereichs hoch ist. Untersuchungen an Lasern, die Strahlung im blauen Spektralbereich emittieren, haben gezeigt, dass die Lebensdauer der Laser umso höher ist, je niedriger die Versetzungsdichte ist. Durch die beschriebene Anordnung des stegförmigen Bereichs bezogen auf die Versetzungsdichteverteilung kann also die Lebensdauer des Halbleiterlasers erhöht werden.

Vorzugsweise ist die Längsachse des stegförmigen Bereichs um mindestens 10 µm, bevorzugt um mindestens 20 µm, beispielsweise um 30 µm oder mehr, bezüglich der Mittelachse des Halbleiterkörpers versetzt angeordnet. Je höher der Versatz zwischen Mittelachse und Längsachse ist, desto mehr Platz steht auf einer Seite des stegförmigen Bereichs auf dem Halbleiterkörper zur Verfügung.

Weiterhin bevorzugt ist die Längsachse des stegförmigen Bereichs um das mindestens 0,05-fache, bevorzugt um das mindestens 0,1-fache, einer Ausdehnung des Halbleiterkörpers in Querrichtung bezüglich der Mittelachse des Halbleiterkörpers versetzt angeordnet.

Auf dem Halbleiterkörper ist eine Kontaktschicht angeordnet. Die Kontaktschicht ist insbesondere für die externe elektrische Kontaktierung des aktiven Bereichs von einer einer Oberseite des stegförmigen Bereichs zugewandten Seite her vorgesehen. Die Kontaktschicht kann weiterhin auch mehrschichtig ausgebildet sein.

Die Kontaktschicht bildet vorzugsweise seitlich des stegförmigen Bereichs eine Kontaktfläche. Die Ausdehnung der Kontaktfläche in Querrichtung beträgt vorzugsweise zumindest bereichsweise mindestens das 0,3-fache, besonders bevorzugt mindestens das 0,4-fache, der Ausdehnung des Halbleiterkörpers. Somit steht auf einer Seite des stegförmigen Bereichs eine vergleichsweise große Kontaktfläche zur Verfügung, die beispielsweise mit einer Drahtbondverbindung extern elektrisch kontaktierbar ist.

Bei einer Breite, also einer Ausdehnung in Querrichtung, des Halbleiterkörpers von etwa 250 µm kann so beispielsweise erzielt werden, dass die Kontaktfläche eine Breite von 80 µm oder mehr, bevorzugt 100 µm oder mehr, aufweist, so dass eine Drahtbondverbindung, beispielsweise mit einem Durchmesser der Bondkugel zwischen 50 µm und 80 µm, vereinfacht mit einem hinreichend großen Abstand zum stegförmigen Bereich ausgebildet werden kann. Die Gefahr einer Schädigung des stegförmigen Bereichs bei der Herstellung der Drahtbondverbindung sowie die Anforderungen an die Genauigkeit des Drahtbondverfahrens sind dadurch vermindert.

Mit anderen Worten führt der Versatz der Längsachse des stegförmigen Bereichs dazu, dass auf einer Seite des stegförmigen Bereichs eine in Querrichtung verbreiterte Kontaktfläche zur Verfügung steht, ohne dass hierfür die Ausdehnung des Halbleiterkörpers vergrößert werden muss. Die Belegung des Aufwachssubstrats durch einen einzelnen Halbleiterkörper kann also gering gehalten werden, so dass auf einem Aufwachssubstrat eine erhöhte Anzahl von Halbleiterkörpern ausgebildet werden kann, wobei dennoch gewährleistet ist, dass die Halbleiterkörper eine hohe Kristallqualität aufweisen und gleichzeitig gut extern elektrisch kontaktierbar sind.

Der Halbleiterkörper, insbesondere der aktive Bereich, basiert vorzugsweise auf einem nitridischen Verbindungshalbleitermaterial.

"Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₓIn_{y}Ga_{1-x-y}N umfasst, wobei 0 ≤ x ≤ 1, 0 ≤ y ≤ 1 und x + y ≤ 1 gilt. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₓIn_{y}Ga_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Mit Halbleiterlasern auf der Basis von Nitrid-Verbindungshalbleitern kann Strahlung vom ultravioletten über den blauen bis in den grünen Spektralbereich erzeugt werden. Selbstverständlich kann aber auch ein anderes Halbleitermaterial, insbesondere ein anderes Verbindungshalbleitermaterial, beispielsweise AlₓIn_{y}Ga_{1-x-y}As mit 0 ≤ x ≤ 1, 0 ≤ y ≤ 1 und x + y ≤ 1 für die Erzeugung von Strahlung im roten oder infraroten Spektralbereich Anwendung finden.

Gemäß einer Ausführungsform wird bei einem Verfahren zur Herstellung einer Mehrzahl von Halbleiterkörpern ein Träger mit einer Vielzahl von Bauelementbereichen, die durch Trennlinien voneinander getrennt sind, bereitgestellt. Auf dem Träger, beispielsweise einem Aufwachssubstrat, wird eine Halbleiterschichtenfolge mit einem zur Erzeugung von Strahlung vorgesehenen aktiven Bereich abgeschieden, vorzugsweise epitaktisch, etwa mittels MBE oder MOCVD. Eine Mehrzahl von stegförmigen Bereichen wird aus der Halbleiterschichtenfolge derart ausgebildet, dass zwischen zwei benachbarten Trennlinien in einer senkrecht zu den Trennlinien verlaufenden Richtung ein erster stegförmiger Bereich und ein zweiter stegförmiger Bereich nebeneinander ausgebildet werden. Zumindest einer der stegförmigen Bereiche ist näher an einer zwischen den benachbarten Trennlinien verlaufenden Mittellinie angeordnet als an der diesem stegförmigen Bereich nächstgelegenen Trennlinie. Die Halbleiterschichtenfolge wird in eine Mehrzahl von Halbleiterkörpern vereinzelt, die jeweils zumindest einen stegförmigen Bereich aufweisen.

Die Trennlinien verlaufen entlang von Bereichen des Trägers, in denen die Versetzungsdichte verglichen zu zwischen den Trennlinien verlaufenden Bereichen erhöht ist. Entsprechend verlaufen die Mittellinien mittig, also äquidistant, zwischen den Trennlinien in einem Bereich, in dem die Versetzungsdichte niedrig und somit die Kristallqualität hoch ist.

Der Träger kann also derart ausgebildet sein, dass die Versetzungsdichte in Querrichtung von der Mittellinie zu den Trennlinien hin zunimmt. Von der Mittellinie ausgehend kann die Versetzungsdichte also zu beiden Trennlinien hin zunehmen. Mit anderen Worten ist die Versetzungsdichte im Bereich der Trennlinien höher als die Versetzungsdichte im Bereich der Mittellinien.

In einer weiteren bevorzugten Ausgestaltung basiert der Träger auf Galliumnitrid (GaN). Galliumnitridsubstrate, die streifenförmige Bereiche hoher Versetzungsdichte (also entlang der Trennlinien verlaufende Bereiche) und dazwischen verlaufende Bereiche niedriger Versetzungsdichte (also entlang der Mittellinie verlaufende Bereiche) aufweisen, sind beispielsweise in der Druckschrift US 6,812,496 B2 beschrieben, deren Offenbarungsgehalt insofern in die vorliegende Anmeldung aufgenommen wird.

Das Vereinzeln erfolgt entlang der Trennlinien und entlang der Mittellinien, also auch zwischen dem ersten stegförmigen Bereich und dem zweiten stegförmigen Bereich.

Mit der Anordnung von zwei stegförmigen Bereichen zwischen zwei benachbarten Trennlinien kann erzielt werden, dass eine besonders hohe Anzahl von Halbleiterbauelementen, insbesondere Halbleiterlasern, bei gleicher Substratgröße auf einem Substrat ausgebildet werden kann. Die Herstellungskosten können dadurch im Vergleich zu einer Anordnung, bei der in Querrichtung lediglich ein Halbleiterkörper aus einem Bereich zwischen zwei benachbarten Trennlinien bei der Herstellung hervorgeht, verringert werden.

Weiterhin ist durch die Anordnung von zumindest einem stegförmigen Bereich zur Mittellinie hin gewährleistet, dass der stegförmige Bereich in einem Bereich hoher Kristallqualität auf dem Substrat ausgebildet wird. Vorzugsweise sind beide stegförmigen Bereiche näher an der Mittellinie angeordnet als an der jeweils nächstgelegenen Trennlinie. Je näher der erste stegförmige Bereich und der zweite stegförmige Bereich an der Mittellinie angeordnet sind, desto höher kann die Kristallqualität im Bereich des stegförmigen Bereichs sein.

Insbesondere können der Halbleiterkörper mit dem ersten stegförmigen Bereich und der Halbleiterkörper mit dem zweiten stegförmigen Bereich bezüglich ihrer Grundform symmetrisch zueinander ausgebildet sein.

In einer Ausgestaltungsvariante bildet die Mittellinie eine Symmetrieachse, so dass die Halbleiterkörper, also der Halbleiterkörper mit dem ersten stegförmigen Bereich und der Halbleiterkörper mit dem zweiten stegförmigen Bereich, achsensymmetrisch zueinander sind.

In einer alternativen Ausgestaltungsvariante sind die Halbleiterkörper punktsymmetrisch zueinander angeordnet, wobei ein Symmetriepunkt vorzugsweise auf der Mittellinie liegt.

Bei einem Substrat, bei dem die Versetzungsdichte ausgehend von der Mittellinie in Richtung der Trennlinien zunimmt, können beide stegförmigen Bereiche jeweils in dem Bereich geringer Versetzungsdichte ausgebildet werden.

Vorzugsweise sind der erste stegförmige Bereich und/oder der zweite stegförmige Bereich um mindestens 10 µm, bevorzugt um mindestens 20 µm, näher an der Mittellinie angeordnet als an der nächstgelegenen Trennlinie.

Eine Kontaktschicht wird derart auf der Halbleiterschichtenfolge ausgebildet, dass den stegförmigen Bereichen jeweils auf der der Mittellinie abgewandten Seite eine zur externen elektrischen Kontaktierung vorgesehene Kontaktfläche zugeordnet ist.

Das beschriebene Verfahren hat zur Folge, dass auf dem Substrat gleichzeitig zwei Halbleiterkörpertypen, nämlich Halbleiterkörper mit dem ersten stegförmigen Bereich und Halbleiterkörper mit dem zweiten stegförmigen Bereich, ausgebildet werden. Dies widerspricht der üblichen Vorgehensweise in der Halbleitertechnologie, auf einem Träger, insbesondere einem Aufwachssubstrat, jeweils ein periodisches Muster vorzusehen, bei dem ausschließlich gleichartige Bauelemente in matrixartiger Anordnung ausgebildet werden, so dass nach dem Vereinzeln alle dabei hervorgehenden Bauelemente dieselbe Struktur aufweisen.

Es hat sich jedoch herausgestellt, dass das Herstellungsverfahren trotz der an sich ungewünschten Ausbildung von zumindest zwei verschiedenen Halbleiterkörpertypen mit jeweils asymmetrischer Anordnung des stegförmigen Bereichs bezüglich der Mittelachse des Halbleiterkörpers verbessert werden kann, da auf diese Weise Halbleiterkörper mit hoher Kristallqualität und einer daraus resultierenden hohen Lebensdauer insgesamt kostengünstiger hergestellt werden können, die zudem besonders einfach extern elektrisch kontaktierbar sind. Weiterhin weisen die einzelnen Halbleiterkörper eine vergleichsweise geringe Streuung hinsichtlich der Lebensdauer und der Emissionsleistung im Betrieb auf, da die stegförmigen Bereiche jeweils in Bereichen des Halbleitermaterials mit vergleichbarer Versetzungsdichte ausgebildet werden.

Die Kontaktschicht wird derart ausgebildet, dass der Halbleiterkörper mit dem ersten stegförmigen Bereich von dem Halbleiterkörper mit dem zweiten stegförmigen Bereich optisch unterscheidbar ist. Auf diese Weise wird sichergestellt, dass die unterschiedlichen Halbleiterkörper den nachfolgenden Herstellungsschritten zuverlässig und eindeutig zuordnungsfähig zugeführt werden können.

In einer bevorzugten Weiterbildung werden die Halbleiterkörper mittels einer automatischen optischen Erkennung voneinander unterschieden, so dass das Herstellungsverfahren trotz der beiden Halbleiterkörpertypen mit hohem Automatisierungsgrad in den nachfolgenden Schritten erfolgen kann.

In einer weiteren bevorzugten Ausgestaltung beträgt eine Ausdehnung der Kontaktfläche mindestens 20 % des Abstands zwischen zwei Trennlinien. Auf diese Weise kann erreicht werden, dass die hergestellten Halbleiterkörper einfach extern elektrisch kontaktierbar sind. Gleichzeitig bedecken die Kontaktflächen aufgrund der asymmetrischen Anordnung der stegförmigen Bereiche nur Bereiche des Substrats, in denen die Versetzungsdichte vergleichsweise hoch ist.

Das beschriebene Verfahren eignet sich insbesondere zur Herstellung eines weiter oben beschriebenen Halbleiterlasers, so dass im Zusammenhang mit dem Verfahren beschriebene Merkmale auch für den Halbleiterlaser herangezogen werden können und umgekehrt.

Weitere Ausgestaltungen und Zweckmäßigkeiten ergeben sich aus der folgenden Beschreibung der Ausführungsbeispiele in Verbindung mit den Figuren.

Es zeigen:
die Figuren 1A und 1B ein Beispiel für einen Halbleiterlaser in schematischer Aufsicht (Figur 1B) und zugehöriger Schnittansicht (Figur 1A); und
die Figuren 2A bis 2D ein Ausführungsbeispiel für ein Herstellungsverfahren anhand von schematisch in Schnittansicht dargestellten Zwischenschritten (Figuren 2A bis 2C) und einer Aufsicht in Figur 2D.

Gleiche, gleichartige oder gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

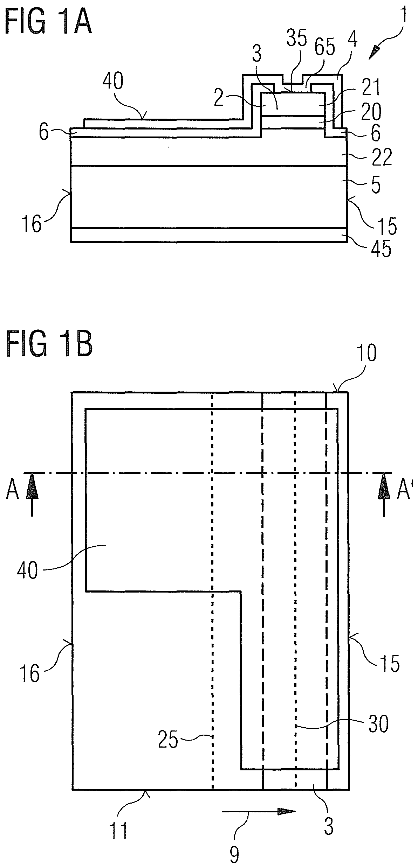

Ein Beispiel für einen Halbleiterlaser ist in schematischer Aufsicht in Figur 1B und in zugehöriger Schnittansicht entlang der Linie AA' in Figur 1A dargestellt, wobei der Halbleiterlaser als ein kantenemittierender Laser in Rippenwellenleitergeometrie (ridge waveguide laser) ausgebildet ist.

Der Halbleiterlaser 1 weist einen Halbleiterkörper 2 auf. Der Halbleiterkörper 2 umfasst eine Halbleiterschichtenfolge mit einem zur Erzeugung von Strahlung vorgesehenen aktiven Bereich 20, einer ersten Halbleiterschicht 21 und einer zweiten Halbleiterschicht 22. Die Halbleiterschichtenfolge bildet den Halbleiterkörper. Der Halbleiterkörper 2 ist auf einem Träger 5 angeordnet. Der Träger 5 kann beispielsweise ein Aufwachssubstrat für die Halbleiterschichtenfolge des Halbleiterkörpers 2 sein.

Als Aufwachssubstrat eignet sich beispielsweise ein Aufwachssubstrat auf der Basis von Galliumnitrid, insbesondere ein Substrat, bei dem Bereiche mit besonders niedriger Versetzungsdichte zwischen streifenförmig ausgebildeten Bereichen höherer Versetzungsdichte angeordnet sind.

Davon abweichend kann der Träger 5 aber auch vom Aufwachssubstrat verschieden sein. In diesem Fall muss der Träger nicht die hohen Anforderungen an die kristalline Qualität eines Aufwachssubstrats erfüllen, sondern kann vielmehr im Hinblick auf andere Eigenschaften wie beispielsweise thermische Leitfähigkeit, thermische Ausdehnung oder kostengünstige Verfügbarkeit ausgewählt werden.

In diesem Fall kann der Träger 5 den Halbleiterkörper 2 mechanisch stabilisieren, sodass das Aufwachssubstrat nicht mehr erforderlich ist und somit entfernt werden kann.

Die erste Halbleiterschicht 21 und die zweite Halbleiterschicht 22 weisen zweckmäßigerweise voneinander verschiedene Leitungstypen auf. Beispielsweise kann die erste Halbleiterschicht p-leitend und die zweite Halbleiterschicht n-leitend ausgebildet sein oder umgekehrt. Die erste Halbleiterschicht und die zweite Halbleiterschicht sind vorzugweise mehrschichtig ausgebildet. Insbesondere können die erste Halbleiterschicht und die zweite Halbleiterschicht jeweils auf der dem aktiven Bereich 20 zugewandten Seite eine Wellenleiterschicht und auf der dem aktiven Bereich abgewandten Seite der Wellenleiterschicht eine Mantelschicht aufweisen. In diesem Fall weisen die Mantelschichten zweckmäßigerweise einen geringeren Brechungsindex als die Wellenleiterschichten auf, sodass die im aktiven Bereich 20 erzeugte Strahlung innerhalb der Wellenleiterschichten geführt wird. Die Mantelschichten und die Wellenleiterschichten sind lediglich zur vereinfachten Darstellung in den Figuren nicht explizit gezeigt.

Der Halbleiterkörper 2 weist eine erste Seitenfläche 15 und eine zweite Seitenfläche 16 auf, die den Halbleiterkörper in Querrichtung begrenzen. Mittig zwischen diesen Seitenflächen verläuft eine Mittelachse 25 des Halbleiterkörpers.

In Längsrichtung weist der Halbleiterkörper 2 eine Strahlungsdurchtrittsfläche 10 und eine der Strahlungsdurchtrittsfläche gegenüberliegende Rückseite 11 auf. Die Strahlungsdurchtrittsfläche und die Rückseite bilden einen Resonator, so dass im aktiven Bereich 20 im Betrieb kohärente Strahlung erzeugt werden kann, wobei die Emissionsrichtung senkrecht oder im Wesentlichen senkrecht zur Strahlungsdurchtrittsfläche verläuft. Zur Beeinflussung der Reflektivität können die Strahlungsdurchtrittsfläche und die Rückseite mit einer Beschichtung versehen sein (in den Figuren nicht explizit dargestellt). Vorzugsweise ist die Reflektivität an der Rückseite höher als an der Strahlungsdurchtrittsfläche.

Weiterhin weist der Halbleiterkörper 2 einen stegförmigen Bereich 3 mit einer in Emissionsrichtung verlaufenden Längsachse 30 auf, wobei mittels des stegförmigen Bereichs ein Rippenwellenleiter ausgebildet ist, der zur Führung der im aktiven Bereich erzeugten kohärenten Strahlung in Querrichtung vorgesehen ist. Die Längsachse ist bezüglich der Mittelachse 25 des Halbleiterkörpers 2 versetzt angeordnet, so dass die Mittelachse näher an der ersten Seitenfläche 15 als an der zweiten Seitenfläche 16 angeordnet ist.

Ein Pfeil 9 veranschaulicht den Verlauf eines Versetzungsdichtegradienten, wobei die Versetzungsdichte in Pfeilrichtung abnimmt. Dies bedeutet, dass der stegförmige Bereich 3 in dem Bereich des Halbleiterkörpers 2 ausgebildet ist, in dem die Versetzungsdichte am geringsten ist. Somit ist die Kristallqualität des Halbleiterkörpers in dem Bereich am höchsten, der für die Erzeugung von Strahlung im Betrieb des Halbleiterlasers maßgeblich ist.

Die Längsachse des stegförmigen Bereichs ist vorzugsweise um mindestens 10 µm, besonders bevorzugt um mindestens 20 µm, beispielsweise um 30 µm oder mehr, bezüglich der Mittelachse des Halbleiterkörpers 2 versetzt angeordnet.

Auf diese Weise ist gewährleistet, dass der stegförmige Bereich 3 eine vergleichsweise hohe Kristallqualität aufweist.

Auf dem Halbleiterkörper 2 ist eine Kontaktschicht 4 ausgebildet. Die Kontaktschicht 4 dient der externen elektrischen Kontaktierung des aktiven Bereichs 2 von einer Oberseite 35 des stegförmigen Bereichs 3 her, beispielsweise mittels einer Drahtbondverbindung.

Auf der dem Halbleiterkörper 2 abgewandten Seite des Trägers 5 ist eine weitere Kontaktschicht 45 ausgebildet, die über den Träger 5 mit der zweiten Halbleiterschicht 22 elektrisch leitend verbunden ist. Mittels der Kontaktschicht 4 und der weiteren Kontaktschicht 45 können im Betrieb des Halbleiterlasers 1 von unterschiedlichen Seiten Ladungsträger in den aktiven Bereich 20 injiziert werden und dort unter Emission von Strahlung rekombinieren.

Weiterhin ist zwischen der Kontaktschicht 4 und dem Halbleiterkörper 2 bereichsweise eine Isolationsschicht 6 angeordnet, die einen elektrischen Kurzschluss des aktiven Bereichs verhindert. Auf der Oberseite 35 des stegförmigen Bereichs 3 weist die Isolationsschicht 6 eine Aussparung 65 auf, in der die Kontaktschicht 4 an die erste Halbleiterschicht 21 angrenzt und eine elektrisch leitende Verbindung zum Halbleiterkörper von der Oberseite 35 des stegförmigen Bereichs herstellt.

Seitlich des stegförmigen Bereichs 3 bildet die Kontaktschicht 4 eine Kontaktfläche 40, die für die externe Kontaktierung mittels eines Bonddrahts vorgesehen ist.

Die Kontaktschicht 4 und/oder die weitere Kontaktschicht 45 enthalten vorzugsweise ein Metall, beispielsweise Gold, Nickel, Titan, Platin, Rhodium, Palladium, Silber, Aluminium oder Chrom oder eine metallische Legierung mit zumindest einem der genannten Metalle. Die Kontaktschichten können auch mehrschichtig ausgebildet sein.

Der aktive Bereich basiert auf einem nitridischen Verbindungshalbleitermaterial und ist für die Erzeugung im ultravioletten, blauen oder grünen Spektralbereich vorgesehen. Selbstverständlich kann auch ein anderes Halbleitermaterial, insbesondere ein III/V-Verbindungshalbleitermaterial, etwa InGaAlAs oder InGaAlP, Anwendung finden.

Die Ausdehnung der Kontaktfläche 40 in Querrichtung beträgt vorzugsweise mindestens das 0,3-fache, besonders bevorzugt mindestens das 0,4-fache der Ausdehnung des Halbleiterkörpers 2. Auf diese Weise ist gewährleistet, dass der Halbleiterkörper von der dem Träger 5 abgewandten Seite her auf einfache Weise elektrisch kontaktierbar ist.

Beispielsweise kann die Ausdehnung der Kontaktfläche in Querrichtung bei einer Breite des Halbleiterkörpers 2 von 200 µm etwa eine Breite von 80 µm oder mehr, beispielsweise 105 µm, aufweisen. So ist gewährleistet, dass der Halbleiterkörper auf einfache und zuverlässige Weise mittels eines Drahtbondverfahrens elektrisch kontaktierbar ist. Im Unterschied dazu bestünde bei einer symmetrischen Anordnung des stegförmigen Bereichs bei einer Breite des Halbleiterkörpers von nur 200 µm die Gefahr, dass die Drahtbondverbindung zu nahe am stegförmigen Bereich entsteht und der stegförmige Bereich beim Herstellen der Drahtbondverbindung beschädigt oder sogar zerstört wird.

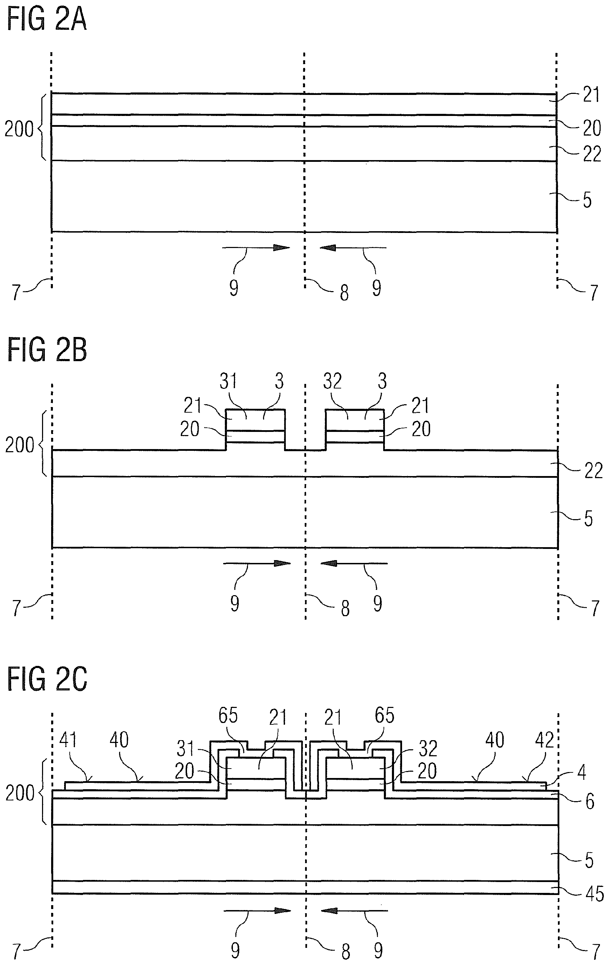

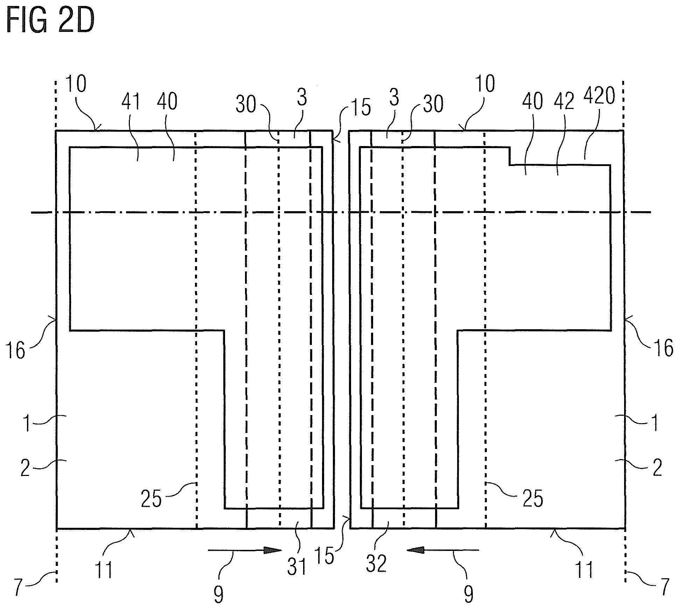

Ein Ausführungsbeispiel für ein Herstellungsverfahren ist anhand von in schematischer Schnittansicht dargestellten Zwischenschritten in den Figuren 2A und 2C und einer Aufsicht in Figur 2D gezeigt.

Wie in Figur 2A dargstellt, wird als Träger 5 ein Substrat bereitgestellt, das eine streifenförmige Strukturierung aufweist. Ein Abstand zwischen zwei benachbarten, parallel zueinander verlaufenden Trennlinien 7 kann zwischen 100 µm und 600 µm, bevorzugt zwischen 200 µm und 500µm, beispielsweise 400 µm, betragen.

Zur vereinfachten Darstellung ist in den Figuren jeweils nur ein zwischen zwei benachbarten Trennlinien 7 verlaufender Bereich des Trägers 5 gezeigt. Auf der Oberfläche des Trägers 5 bilden die Trennlinien 7 ein streifenförmiges Muster, wobei die Defektdichte entlang der Trennlinien höher ist als zwischen den Trennlinien. In den Figuren ist weiterhin zur Veranschaulichung eine Mittellinie 8 gezeigt, die im halben Abstand zwischen den Trennlinien 7 parallel zu diesen verläuft.

Die Pfeile 9 veranschaulichen den Gradienten der Versetzungsdichte, welche von der Mittellinie 8 zu den Trennlinien 7 hin zunimmt, so dass im Bereich um die Mittellinien die Kristallqualität des Trägers jeweils am höchsten ist.

Auf dem Träger 5 wird eine Halbleiterschichtenfolge 200 mit einem aktiven Bereich 20, einer ersten Halbleiterschicht 21 und einer zweiten Halbleiterschicht 22 epitaktisch abgeschieden, beispielsweise mittels MBE oder MOCVD.

Die Halbleiterschichtenfolge 200 wird derart strukturiert, dass stegförmige Bereiche 3 ausgebildet werden, die in Aufsicht auf den Träger eine parallel zu den Trennlinien 7 verlaufende Längsachse 30 aufweisen (Figur 2B).

Die Strukturierung kann beispielsweise mittels nasschemischen oder trockenchemischen Ätzens erfolgen.

Die Strukturierung erfolgt hierbei derart, dass zwischen zwei benachbarten Trennlinien 7 ein erster stegförmiger Bereich 31 und ein zweiter stegförmiger Bereich 32 in Querrichtung nebeneinander ausgebildet werden. Die stegförmigen Bereiche 31, 32 sind jeweils näher an der Mittellinie 8 angeordnet als an der jeweils nächstgelegenen Trennlinie 7. So kann erzielt werden, dass beide stegförmigen Bereiche nahe an der Mittellinie angeordnet sind und somit eine hohe kristalline Qualität aufweisen können.

Weiterhin sind der Halbleiterkörper 2 mit dem ersten stegförmigen Bereich 31 und der Halbleiterkörper mit dem zweiten stegförmigen Bereich 32 achsensymmetrisch bezüglich der Mittellinie ausgebildet.

Bei der späteren Vereinzelung entlang der Trennlinien 7 und der Mittellinie 8 gehen somit zwei verschiedene Halbleiterkörpertypen aus dem Waferverbund hervor, wobei in Emissionsrichtung gesehen bei dem Halbleiterkörper mit dem ersten stegförmigen Bereich 31 der stegförmige Bereich gegenüber der Mittelachse 25 nach rechts versetzt und der zweite stegförmige Bereich 32 gegenüber der Mittelachse 25 nach links versetzt ist (Figur 2D).

Bei einer herkömmlichen Anordnung der stegförmigen Bereiche mittig zu den Halbleiterkörpern, also ohne Versatz zwischen Mittelachse des Halbleiterkörpers und der Längsachse des stegförmigen Bereichs, würden dagegen die stegförmigen Bereiche näher an den Trennlinien verlaufen und daher eine verringerte Kristallqualität aufweisen.

Wie in Figur 2C dargestellt, wird auf der strukturierten Halbleiterschichtenfolge 200 eine Isolationsschicht 6 ausgebildet, welche auf einer Oberseite der stegförmigen Bereiche 31, 32 jeweils Aussparungen 65 aufweist. Die Isolationsschicht ist insbesondere dafür vorgesehen, den aktiven Bereich 20 vor einem elektrischen Kurzschluss zu schützen.

Als Material für die Isolationsschicht eignet sich beispielsweise ein Nitrid, etwa Siliziumnitrid, oder ein Oxid, etwa Titanoxid oder Siliziumoxid, oder ein Oxinitrid, etwa Siliziumoxinitrid.

Nachfolgend wird auf der Halbleiterschichtenfolge 200 eine Kontaktschicht 4 abgeschieden, welche durch die Aussparungen 65 hindurch einen elektrischen Kontakt zur ersten Halbleiterschicht 21 im Bereich der stegförmigen Bereiche 31, 32 ausbildet.

Seitlich des ersten stegförmigen Bereichs 31 und des zweiten stegförmigen Bereichs 32 entstehen dadurch eine erste Kontaktfläche 41 beziehungsweise eine zweite Kontaktfläche 42, die für die externe elektrische Kontaktierung des Halbleiterlasers vorgesehen sind.

Eine Ausdehnung der Kontaktflächen in Querrichtung beträgt vorzugsweise mindestens 20 % des Abstands zwischen zwei benachbarten Trennlinien.

Auf der der Halbleiterschichtenfolge 200 abgewandten Seite des Trägers 5 wird weiterhin eine weitere Kontaktschicht 45 abgeschieden, die der unterseitigen externen elektrischen Kontaktierung dient.

Die Abscheidung der Kontaktschicht 4 und/oder der weiteren Kontaktschicht 45 kann beispielsweise mittels Sputterns oder Aufdampfens erfolgen. Weiterhin können die Kontaktschicht und/oder die weitere Kontaktschicht auch mehrschichtig ausgebildet sein.

Nach einer Vereinzelung senkrecht zu den Trennlinien 7 kann eine Beschichtung der Strahlungsdurchtrittsfläche 10 und der Rückseite 11 erfolgen. Dies kann insbesondere durchgeführt werden, bevor die Halbleiterkörper entlang der Trennlinien 7 und entlang der Mittellinien 8 vereinzelt werden.

Zur Fertigstellung der Halbleiterlaser wird der Träger entlang der Trennlinie 7 und der Mittellinien 8 zerteilt. Nach Abschluss der Vereinzelung verlaufen jeweils die ersten Seitenflächen 15 der Halbleiterkörper 2 entlang der Mittellinie 8 und die zweiten Seitenflächen 16 entlang der Trennlinien 7.

Dieses Zerteilen kann insbesondere mechanisch, beispielsweise mittels Spaltens, Brechens, Ritzens oder Sägens, chemisch, beispielsweise mittels nasschemischen oder trockenchemischen Ätzens, und/oder mittels kohärenter Strahlung, etwa Laserstrahlung, erfolgen.

Wie in Figur 2D dargestellt, unterscheiden sich der Halbleiterkörper mit dem ersten stegförmigen Bereich 31 und der Halbleiterkörper mit dem zweiten stegförmigen Bereich 32 hinsichtlich ihrer Grundform neben der versetzten Anordnung der stegförmigen Bereiche auch dadurch, dass die Kontaktflächen 41 bzw. 42 in Richtung der Strahlungsdurchtrittsfläche 10 gesehen auf unterschiedlichen Seiten des stegförmigen Bereichs angeordnet sind.

Weiterhin weist die Kontaktfläche 42 eine Markierung 420 auf, anhand derer die Halbleiterkörper 2 nach der Vereinzelung vereinfacht voneinander unterschieden werden können, beispielsweise mittels einer automatischen optischen Erkennung. So kann sichergestellt werden, dass die Halbleiterkörper nachfolgenden Herstellungsschritten zuverlässig und automatisierbar zugeführt werden können. Eine Unterscheidung anhand der Kontaktschicht ist besonders günstig, da diese wegen ihrer typischerweise metallischen Oberfläche einen starken Kontrast zur restlichen Oberfläche des Halbleiterlasers bietet.

Die Markierung ist in diesem Ausführungsbeispiel lediglich beispielhaft als ein Bereich ausgeführt, in dem die Größe der zweiten Kontaktfläche 42 gegenüber der Größe der ersten Kontaktfläche 41 verringert ist. Von der Erfindung abweichend kann auch eine andere Art der Markierung ausgebildet werden, wobei die Markierungen auch als gesonderte Bereiche auf dem Halbleiterkörper ausgebildet werden können, die nicht notwendigerweise auch der elektrischen Kontaktierung des Halbleiterkörpers 2 dienen müssen.

Beispielsweise kann die Markierung 420 auch in Form von Schriftzeichen, etwa Zahlen und/oder Buchstaben, auf dem Halbleiterkörper 2 ausgebildet sein, die von den Kontaktflächen 40 beabstandet sind.

In dem beschriebenen Ausführungsbeispiel wurde lediglich exemplarisch ein stegförmiger Bereich 3 gezeigt, bei dem der aktive Bereich 20 im stegförmigen Bereich ausgebildet ist. Davon abweichend kann der stegförmige Bereich 3 auch derart ausgebildet sein, dass der aktive Bereich 20 bei der Strukturierung nicht durchtrennt wird, so dass lediglich die erste Halbleiterschicht 21 den stegförmigen Bereich bildet. In diesem Fall kann auf die Isolationsschicht 6 auch verzichtet werden. Ferner ist auch denkbar, den stegförmigen Bereich außerhalb des Halbleiterkörpers auszubilden, beispielsweise in Form eines streifenförmigen Bereichs der Kontaktschicht 4.

Weiterhin können von dem beschriebenen Ausführungsbeispiel abweichend die Halbleiterkörper 2 mit dem ersten stegförmigen Bereich 31 und die Halbleiterkörper mit dem zweiten stegförmigen Bereich 32 auch punktsymmetrisch zueinander ausgebildet sein, insbesondere mit einem Symmetriepunkt auf der Mittellinie 8. Dadurch kann erzielt werden, dass beim Vereinzeln des Trägers gleichartige Halbleiterlaser hervorgehen.

In diesem Fall befinden sich die Strahlungsdurchtrittsfläche des Halbleiterkörpers mit dem ersten stegförmigen Bereich 31 und die Strahlungsdurchtrittsfläche des Halbleiterkörpers mit dem zweiten stegförmigen Bereich 32 vor der Vereinzelung entlang der Mittellinie 8 auf unterschiedlichen Seiten. Daher erfolgt eine Beschichtung der Strahlungsdurchtrittsfläche 10 und der Rückseite 11 vorzugsweise nach dem Vereinzeln der Halbleiterkörper, so dass die Rückseiten jeweils eine höhere Reflektivität aufweisen können als die Strahlungsdurchtrittsflächen.

## Patentansprüche

1. Verfahren zur Herstellung einer Mehrzahl von Halbleiterkörpern mit den Schritten:
a) Bereitstellen eines Trägers (5) mit einer Vielzahl von Bauelementbereichen, die durch Trennlinien (7) voneinander getrennt sind;
b) Abscheiden einer Halbleiterschichtenfolge (200) mit einem zur Erzeugung von Strahlung vorgesehenen aktiven Bereich (20);
c) Ausbilden einer Mehrzahl von stegförmigen Bereichen (3) aus der Halbleiterschichtenfolge derart, dass zwischen zwei benachbarten Trennlinien in einer senkrecht zu den Trennlinien verlaufenden Richtung genau zwei stegförmige Bereiche nebeneinander ausgebildet werden, wobei die Trennlinien entlang von Bereichen des Trägers verlaufen, in denen eine Versetzungsdichte verglichen zu zwischen den Trennlinien verlaufenden Bereichen erhöht ist und zumindest ein erster stegförmiger Bereich (31) oder ein zweiter stegförmiger Bereich (32) der stegförmigen Bereiche näher an einer zwischen den benachbarten Trennlinien verlaufenden Mittellinie (8) angeordnet ist als an der diesem stegförmigen Bereich nächstgelegenen Trennlinie, wobei die Versetzungsdichte ausgehend von der Mittellinie in Richtung der Trennlinien zunimmt und wobei auf der Halbleiterschichtenfolge eine Kontaktschicht (4) derart ausgebildet wird, dass den stegförmigen Bereichen jeweils auf der der Mittellinie abgewandten Seite eine zur externen elektrischen Kontaktierung des aktiven Bereichs vorgesehene Kontaktfläche (41, 42) zugeordnet ist; und
d) Vereinzeln der Halbleiterschichtenfolge entlang der Trennlinien und entlang der Mittellinie in eine Mehrzahl von Halbleiterkörpern (2), die jeweils zumindest einen stegförmigen Bereich aufweisen;
**dadurch gekennzeichnet, dass** in Schritt c) mittels der Kontaktfläche eine Markierung (420) ausgebildet wird, anhand derer der Halbleiterkörper mit dem ersten stegförmigen Bereich und der Halbleiterkörper mit dem zweiten stegförmigen Bereich optisch voneinander unterscheidbar sind.

2. Verfahren nach Anspruch 1,
bei dem beide stegförmige Bereiche näher an der Mittellinie angeordnet sind als an der jeweils nächstgelegenen Trennlinie.

3. Verfahren nach Anspruch 1 oder 2,
bei dem die Mittellinie eine Symmetrieachse bildet, zu der der Halbleiterkörper mit dem ersten stegförmigen Bereich und der Halbleiterkörper mit dem zweiten stegförmigen Bereich achsensymmetrisch zueinander sind.

4. Verfahren nach einem der Ansprüche 1 bis 3,
bei dem der Halbleiterkörper mit dem ersten stegförmigen Bereich und der Halbleiterkörper mit dem zweiten stegförmigen Bereich mittels einer automatischen optischen Erkennung voneinander unterschieden werden.

5. Verfahren nach einem der Ansprüche 1 bis 4,
bei dem eine Ausdehnung der Kontaktfläche mindestens 20 % des Abstands zwischen zwei Trennlinien beträgt.

6. Verfahren nach einem der Ansprüche 1 bis 5,
bei dem der Träger auf GaN basiert.

7. Verfahren nach einem der Ansprüche 1 bis 6,
bei dem dem Halbleiterkörper mit dem ersten stegförmigen Bereich eine erste Kontaktfläche (41) und dem Halbleiterkörper mit dem zweiten stegförmigen Bereich eine zweite Kontaktfläche (42) zugeordnet sind, wobei die Markierung als ein Bereich ausgeführt ist, in dem die Größe der ersten Kontaktfläche gegenüber der Größe der zweiten Kontaktfläche verringert ist.

## Claims

1. A method for producing a plurality of semiconductor bodies comprising the following steps:
a) providing a carrier (5) having a multiplicity of component regions separated from one another by separating lines (7);
b) depositing a semiconductor layer sequence (200) having an active region (20) provided for generating radiation;
c) forming a plurality of ridge-shaped regions (3) from the semiconductor layer sequence in such a way that exactly two ridge-shaped regions are formed alongside one another between two adjacent separating lines in a direction running perpendicular to the separating lines, wherein the separating lines run along regions of the carrier, in which a dislocation density is increased in comparison to regions extending between the separating lines and at least a first ridge-shaped region (31) or a second ridge-shaped region (32) of the ridge-shaped regions is arranged closer to a central line (8) running between the adjacent separating lines than to the separating line situated closest to said ridge-shaped region, where the dislocation density increases proceeding from the central line in the direction of the separating lines und wherein a contact layer (4) is formed on the semiconductor layer sequence in such a way that a contact area (41, 42) provided for external electrical contact-connection is assigned to the ridge-shaped regions in each case on the side facing away from the central line; and
d) singulating the semiconductor layer sequence along the separating lines and along the central line into a plurality of semiconductor bodies (2) each having at least one ridge-shaped region;
**characterized in that**
in step c) a marking 420 is formed by means of the contact area, on the basis of which the semiconductor body with the first ridge-shaped region and the semiconductor body with the second ridge-shaped region can be distinguished from one another optically.

2. Method according to claim 1,
wherein both ridge-shaped regions are arranged closer to the central line than to the separating line respectively situated closest.

3. Method according to claim 1 or 2,
wherein the central line forms an axis of symmetry, such that the semiconductor body having the first ridge-shaped region and the semiconductor body having the second ridge-shaped region are axially symmetrical with respect to one another.

4. Method according to one of the claims 1 to 3,
wherein the semiconductor body having the first ridge-shaped region and the semiconductor body having the second ridge-shaped region are distinguished from one another by means of an automatic optical recognition.

5. Method according to one of the claims 1 to 4,
wherein an extent of the contact area is at least 20% of the distance between two separating lines.

6. Method according to one of the claims 1 to 5, wherein the carrier is based on GaN.

7. Method according to one of the claims 1 to 6,
wherein a first contact area 41 is assigned to the semiconductor body having the first ridge-shaped region and a second contact area 42 is assigned to the semiconductor body having the second ridge-shaped region, wherein the marking is embodied as a region in which the size of the first contact area is reduced relative to the size of the second contact area.

## Revendications

1. Procédé de fabrication d'une pluralité de corps semi-conducteurs, comprenant les étapes :
a) fourniture d'un support (5) doté d'une pluralité de zones de composants qui sont séparées les unes des autres par des lignes de séparation (7) ;
b) dépôt d'une succession de couches semi-conductrices (200) comprenant une zone active (20) prévue pour générer un rayonnement ;
c) réalisation, à partir de la succession de couches semi-conductrices, d'une pluralité de zones (3) en forme de nervure, de manière à ce qu'entre deux lignes de séparation voisines, exactement deux zones en forme de nervure soient réalisées l'une à côté de l'autre dans une direction s'étendant perpendiculairement aux lignes de séparation, les lignes de séparation s'étendant le long de zones du support dans lesquelles une densité de dislocation, comparée à des zones s'étendant entre les lignes de séparation, est plus élevée, et au moins une première zone (31) en forme de nervure ou une deuxième zone (32) en forme de nervure des zones en forme de nervure étant disposée de manière plus proche d'une ligne médiane (8) s'étendant entre les lignes de séparation voisines que de la ligne de séparation la plus proche de cette zone en forme de nervure, la densité de dislocation, en partant de la ligne médiane, augmentant en direction des lignes de séparation, et une couche de contact (4) étant réalisée sur la succession de couches semi-conductrices de manière à ce qu'une surface de contact (41, 42) prévue respectivement sur le côté détourné de la ligne médiane soit assignée aux zones en forme de nervure pour la mise en contact électrique externe de la zone active ; et
d) individualisation de la succession de couches semi-conductrices le long des lignes de séparation et le long de la ligne médiane en une pluralité de corps semi-conducteurs (2) qui présentent respectivement au moins une zone en forme de nervure ;
**caractérisé en ce qu'**
à l'étape c), un marquage (420) est réalisé au moyen de la surface de contact, à l'aide duquel le corps semi-conducteur ayant la première zone en forme de nervure et le corps semi-conducteur ayant la deuxième zone en forme de nervure peuvent être optiquement distingués l'un de l'autre.

2. Procédé selon la revendication 1,
dans lequel les deux zones en forme de nervure sont disposées plus près de la ligne médiane que de la ligne de séparation respectivement la plus proche.

3. Procédé selon la revendication 1 ou 2,
dans lequel la ligne médiane forme un axe de symétrie par rapport auquel le corps semi-conducteur ayant la première zone en forme de nervure et le corps semi-conducteur ayant la deuxième zone en forme de nervure sont en symétrie d'axe l'un par rapport à l'autre.

4. Procédé selon l'une quelconque des revendications 1 à 3, dans lequel le corps semi-conducteur ayant la première zone en forme de nervure et le corps semi-conducteur ayant la deuxième zone en forme de nervure sont distingués l'un de l'autre au moyen d'une identification optique automatique.

5. Procédé selon l'une quelconque des revendications 1 à 4, dans lequel une étendue de la surface de contact est d'au moins 20% de l'écart entre deux lignes de séparation.

6. Procédé selon l'une quelconque des revendications 1 à 5, dans lequel le support est à base de GaN.

7. Procédé selon l'une quelconque des revendications 1 à 6, dans lequel une première surface de contact (41) est assignée au corps semi-conducteur ayant la première zone en forme de nervure et dans lequel une deuxième surface de contact (42) est assignée au corps semi-conducteur ayant la deuxième zone en forme de nervure, le marquage étant réalisé en tant qu'une zone dans laquelle la taille de la première surface de contact est réduite par rapport à la taille de la deuxième surface de contact.
